# EUROPÄISCHE PATENTSCHRIFT

(11) **EP 1 995 836 B1**
(45) Veröffentlichungstag und Bekanntmachung des Hinweises auf die Patenterteilung: **04.09.2013**
(21) Anmeldenummer: 08009304.0
(22) Anmeldetag: 20.05.2008
(51) Int. Cl.: H01L 29/205, H01L 33/14, H01S 5/30, H01S 5/32, H01L 33/30, H01L 33/02, H01S 5/343

(54) **Halbleiterchip und Verfahren zur Herstellung eines Halbleiterchips**
Semiconductor chip and method for manufacturing the same
Puce semi-conductrice et procédé de fabrication d'une puce semi-conductrice

(30) Priorität: 23.05.2007 DE 102007023878
(43) Veröffentlichungstag der Anmeldung: 26.11.2008
(73) Patentinhaber: OSRAM Opto Semiconductors GmbH, 93055 Regensburg (DE)
(72) Erfinder: Mayer, Bernd, Dr., 93059 Regensburg (DE); Schmid, Wolfgang, Dr., 93180 Deuerling / Hillohe (DE)
(74) Vertreter: Epping - Hermann - Fischer

(56) Entgegenhaltungen:
- JP-A- 6 077 587
- US-A- 6 148 013
- US-A1- 2003 118 066
- US-A1- 2005 271 104
- US-A1- 2006 273 329
- MESRINE M ET AL: "Indium surface segregation during chemical beam epitaxy of Ga1-xInxAs/GaAs and Ga1-xInxP/GaAs heterostructures" JOURNAL OF CRYSTAL GROWTH, ELSEVIER, AMSTERDAM, NL, Bd. 175-176, 1. Mai 1997 (1997-05-01), Seiten 1242-1246, XP004091475 ISSN: 0022-0248

## Beschreibung

Die Erfindung betrifft einen Halbleiterchip und ein Verfahren zur Herstellung eines derartigen Halbleiterchips.

Diese Patentanmeldung beansprucht die Priorität der deutschen Patentanmeldung Nr. 102007023878.0.

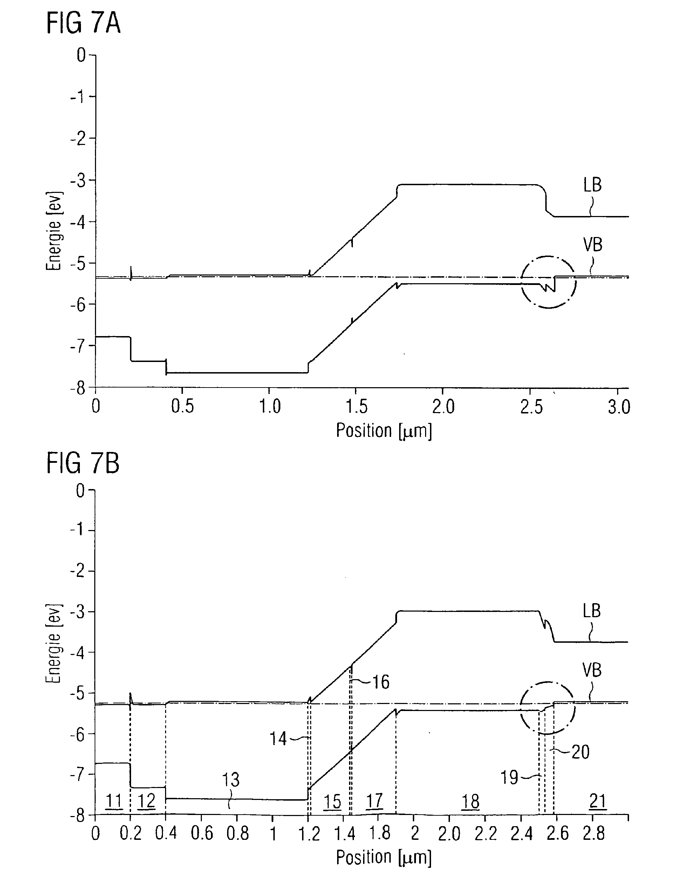

Bei einem herkömmlichen auf InGaA1P-basierenden Bauelement, das mittels MOVPE (Metal Organic chemical Vapor Phase Epitaxy) hergestellt wird, kann eine p-seitige Kontaktschicht p-dotiertes GaAs aufweisen. Das p-dotierte GaAs wird üblicherweise bei einer im Vergleich zur Herstellungstemperatur vorausgehender Schichten niedrigeren Temperatur abgeschieden. Ein Abkühlen auf diese Temperatur erfolgt typischerweise unter PH₃-Stützdruck. Ein so verursachter hoher PH₃-Eintrag in eine Reaktorkammer kann aufgrund des hohen Dampfdrucks von Phosphor negative Folgen für die Kristallqualität des weiteren Wachstums haben. Ferner tritt typischerweise an einem Übergang von der Kontaktschicht zu einer Mantelschicht ein hoher Bandoffset auf. In der Regel wird dieser Bandoffset durch eine p-dotierte Zwischenschicht reduziert, die InGaP enthält. Trotzdem können noch stufenförmige Barrieren auftreten, die eine Löcherleitung erschweren (vgl. Figur 7A). Denn mittels Dotierung kann zwar eine Ausdehnung der Barrieren, jedoch nicht deren Höhe reduziert werden.

In der Patentschrift US 5,619,519 ist ein Halbleiterlaserbauelement mit einer ersten Mantelschicht und einer zweiten Mantelschicht beschrieben, wobei zwischen der zweiten Mantelschicht und einer Abdeckschicht eine Zwischenschicht angeordnet ist.

Die Patentschrift US 6,148,013 beschreibt einen Halbleiterchip gemäß dem Oberbegriff des Patentanspruchs 1.

Es ist eine Aufgabe der vorliegenden Erfindung, einen Halbleiterchip mit verbesserten elektrischen Eigenschaften anzugeben.

Diese Aufgabe wird durch einen Halbleiterchip gemäß Patentanspruch 1 gelöst.

Eine weitere Aufgabe der vorliegenden Erfindung ist es, ein vereinfachtes Verfahren zur Herstellung eines derartigen Halbleiterchips anzugeben.

Diese Aufgabe wird durch ein Verfahren gemäß Patentanspruch 6 gelöst.

Vorteilhafte Ausgestaltungen und Weiterbildungen des Halbleiterchips sowie des Verfahrens zur Herstellung eines derartigen Halbleiterchips sind Gegenstand der abhängigen Ansprüche.

Ein erfindungsgemäßer Halbleiterchip umfasst einen p-dotierten Bereich, der eine Mantelschicht und eine Kontaktschicht aufweist, wobei zwischen der Mantelschicht und der Kontaktschicht eine erste Zwischenschicht und eine zweite Zwischenschicht angeordnet sind und wobei sich eine Konzentration y einer ersten Materialkomponente innerhalb der ersten und der zweiten Zwischenschicht derart ändert, dass die Bandlücke innerhalb der ersten und der zweiten Zwischenschicht in einem Bereich variiert, der zwischen der Bandlücke der Mantelschicht und der Bandlücke der Kontaktschicht liegt.

Vorteilhafterweise kann mittels der ersten und zweiten Zwischenschicht eine sprunghafte Größenänderung der Bandlücke am Übergang von der Kontaktschicht zur Mantelschicht verhindert werden. Denn die erste und die zweite Zwischenschicht ermöglichen eine graduelle Anpassung der Größe der Bandlücke zwischen der Kontaktschicht und der Mantelschicht.

Die Größe der Bandlücke nimmt innerhalb der ersten Zwischenschicht ausgehend von der Mantelschicht bis hin zur zweiten Zwischenschicht ab. Dies wird dadurch erreicht, dass die Konzentration y der ersten Materialkomponente innerhalb der ersten Zwischenschicht ausgehend von der Mantelschicht bis hin zur zweiten Zwischenschicht abnimmt. Diese Ausgestaltung hat zur Folge, dass der Spannungsabfall in Stromflussrichtung reduziert ist und der serielle Widerstand des Halbleiterchips deutlich kleiner ist als bei einem herkömmlichen Halbleiterchip.

Weiterhin nimmt die Bandlücke innerhalb der zweiten Zwischenschicht ausgehend von der ersten Zwischenschicht bis hin zur Kontaktschicht ab. Dies wird dadurch erreicht, dass die Konzentration y der ersten Materialkomponente innerhalb der zweiten Zwischenschicht ausgehend von der ersten Zwischenschicht bis hin zur Kontaktschicht abnimmt. Auch in diesem Fall kann eine graduelle Änderung der Größe der Bandlücke beziehungsweise der Konzentration der ersten Materialkomponente eine Reduzierung des seriellen Widerstands des Halbleiterchips bewirken.

Für die Mantelschicht, die erste Zwischenschicht, die zweite Zwischenschicht und die Kontaktschicht wird jeweils ein Verbindungshalbleitermaterial verwendet. Dieses Verbindungshalbleitermaterial kann insbesondere ein III-V-Verbindungshalbleitermaterial sein. Gemäß einer bevorzugten Variante ist das Verbindungshalbleitermaterial der ersten Zwischenschicht ein quarternäres Verbindungshalbleitermaterial, insbesondere ein auf Phosphid basierendes Halbleitermaterial, während das Verbindungshalbleitermaterial der zweiten Zwischenschicht ein ternäres Verbindungshalbleitermaterial, insbesondere ein auf Arsenid basierendes Halbleitermaterial, ist. Ferner kann die Mantelschicht ein auf Phosphid basierendes Halbleitermaterial aufweisen, während die Kontaktschicht ein auf Arsenid basierendes Halbleitermaterial enthält.

Eine Zusammensetzung des jeweiligen Verbindungshalbleitermaterials kann durch folgende Formel beschrieben werden: CₓB_{y(1-x)}E_{(1-y) (1-x)}A, wobei 0 ≤ x ≤ 1 und 0 ≤ y ≤ 1 ist. Die Buchstaben A, B, C, E stehen für die einzelnen Materialkomponenten, aus denen das Verbindungshalbleitermaterial zusammengesetzt ist. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die physikalischen Eigenschaften, insbesondere die Kristallstruktur oder Bandstruktur, des Materials im Wesentlichen nicht ändern. Beispielsweise kann die erste Materialkomponente (B) Aluminium, eine zweite Materialkomponente (E) Gallium, eine dritte Materialkomponente (C) Indium und eine vierte Materialkomponente (A) Phosphor oder Arsen sein.

Während vorliegend eine Änderung der Konzentration y der ersten Materialkomponente und somit auch der Konzentration (1-y) der zweiten Materialkomponente innerhalb der ersten und zweiten Zwischenschicht vorgesehen ist, kann die Konzentration x der dritten Materialkomponente in diesem Fall konstant sein. Es ist jedoch auch denkbar, dass die Konzentration x der dritten Materialkomponente variiert.

Im Rahmen der Erfindung werden unter der Konzentration der ersten Materialkomponente und der zweiten Materialkomponente die Parameter y bzw. 1-y verstanden. Es leuchtet ein, dass zur genauen Berechnung der Materialzusammensetzung auch der Parameter x berücksichtigt werden muss.

Die Konzentration der ersten Materialkomponente weist in der Mantelschicht vorzugsweise einen konstanten Wert von y = 100% auf. Darüberhinaus kann die Kontaktschicht die zweite Materialkomponente in einer konstanten Konzentration von 1-y = 100% aufweisen. Beispielsweise kann die Mantelschicht InA1P enthalten, während die Kontaktschicht GaAs aufweist.

Vorteilhafterweise kann mittels einer Änderung des Aluminiumgehalts in der ersten und zweiten Zwischenschicht die Bandlücke in einem Bereich variiert werden, der zwischen der Bandlücke der Mantelschicht und der Kontaktschicht liegt. Ferner wird der Gehalt der ersten Materialkomponente beziehungsweise der Aluminiumgehalt an der Grenzfläche zwischen der ersten und der zweiten Zwischenschicht vorzugsweise derart gewählt, dass eine Energiebarriere, welche die Löcher überwinden müssen, vergleichsweise klein ist.

Gemäß einer bevorzugten Variante enthalten die Mantelschicht InAlP, die erste Zwischenschicht InAlGaP, die zweite Zwischenschicht AlGaAs und die Kontaktschicht GaAs.

Gemäß einer weiter bevorzugten Variante beträgt die Konzentration y der ersten Materialkomponente innerhalb der ersten Zwischenschicht auf einer der Mantelschicht zugewandten Seite zwischen einschließlich 20% und 100%. Insbesondere kann die Konzentration y zwischen einschließlich 70% und 90% betragen. Besonders bevorzugt sinkt die Konzentration y der ersten Materialkomponente innerhalb der ersten Zwischenschicht auf einer der zweiten Zwischenschicht zugewandten Seite auf einen Wert zwischen einschließlich 0% und 50% ab. Insbesondere kann die Konzentration y der ersten Materialkomponente innerhalb der ersten Zwischenschicht auf einer der zweiten Zwischenschicht zugewandten Seite auf einen Wert zwischen einschließlich 10% und 40% absinken.

Vorzugsweise weist ein Valenzband ausgehend von der Mantelschicht bis hin zur Kontaktschicht einen kontinuierlichen Verlauf auf. Insbesondere kann der Verlauf der Konzentration y der ersten Materialkomponente in einer Wachstumsrichtung, in welcher die Schichten aufgewachsen sind, innerhalb der ersten Zwischenschicht einer Gerade mit einer Steigung ungleich Null gleichen, das heißt die Konzentration ändert sich kontinuierlich in der Wachstumsrichtung und weist insbesondere einen linearen Verlauf auf. Es ist jedoch auch eine stufenartige Änderung der Konzentration denkbar.

Bei einer bevorzugten Ausgestaltung des Halbleiterchips beträgt die Konzentration y der ersten Materialkomponente innerhalb der zweiten Zwischenschicht auf einer der ersten Zwischenschicht zugewandten Seite zwischen einschließlich 10% und 100%. Insbesondere kann die Konzentration y der ersten Materialkomponente innerhalb der zweiten Zwischenschicht auf einer der ersten Zwischenschicht zugewandten Seite zwischen einschließlich 60% und 80% betragen. Weiterhin sinkt die Konzentration y der ersten Materialkomponente innerhalb der zweiten Zwischenschicht auf einer der Kontaktschicht zugewandten Seite vorzugsweise auf einen Wert zwischen einschließlich 0% und 50%. Insbesondere kann die Konzentration y der ersten Materialkomponente innerhalb der zweiten Zwischenschicht auf einer der Kontaktschicht zugewandten Seite auf einen Wert zwischen einschließlich 2% und 5% absinken. Auch hier gilt wie im Falle der ersten Zwischenschicht, dass die Konzentration y kontinuierlich, insbesondere linear,oder stufenartig abnehmen kann.

Der Halbleiterchip weist insbesondere einen aktiven Bereich auf, der zwischen dem p-dotierten Bereich und einem n-dotierten Bereich angeordnet ist. Vorzugsweise wird bei Betrieb des Halbleiterchips im aktiven Bereich Strahlung erzeugt. Somit kann der Halbleiterchip als Strahlung emittierender Halbleiterchip bezeichnet werden. Zur Strahlungserzeugung umfasst der aktive Bereich vorzugsweise einen Strahlung erzeugenden pn-Übergang. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden aktiven Schicht die eigentliche Strahlung erzeugende Schicht, etwa in Form einer dotierten oder undotierten Quantenschicht, ausgebildet. Die Quantenschicht kann als Einfachquantentopfstuktur (SQW, Single Quantum Well) oder Mehrfachquantentopfstruktur (MQW, Multiple Quantum Well) oder auch als Quantendraht oder Quantenpunktstruktur ausgeformt sein.

Gemäß einer bevorzugten Ausführungsform ist der Halbleiterchip ein Laserdiodenchip. In diesem Fall erzeugt der Halbleiterchip kohärente Strahlung. Alternativ kann der Halbleiterchip beispielsweise in der Ausgestaltung als Leuchtdiode inkohärente Strahlung erzeugen.

Ein erfindungsgemäßes Verfahren zur Herstellung eines Halbleiterchips gemäß einem der oben beschriebenen Varianten weist folgende Schritte auf:
- Aufwachsen der ersten Zwischenschicht auf die Mantelschicht,
- Aufwachsen der zweiten Zwischenschicht auf die erste Zwischenschicht,
- Aufwachsen der Kontaktschicht auf die zweite Zwischenschicht.

Bei einer bevorzugten Variante erfolgt ein Aufwachsen der zweiten Zwischenschicht auf die erste Zwischenschicht ohne Wachstumsunterbrechung. Vorteilhafterweise kann hierdurch die Herstellungszeit für den Halbleiterchip verkürzt werden. Alternativ kann das Aufwachsen der zweiten Zwischenschicht auf die erste Zwischenschicht jedoch auch mit Wachstumsunterbrechung erfolgen.

Vorzugsweise wird der Halbleiterchip mittels MOVPE hergestellt.

Gemäß einer vorteilhaften Variante wird zwischen dem Aufwachsen der ersten und der zweiten Zwischenschicht von Phosphor-basierendem Wachstum auf Arsen-basierendes Wachstum umgeschaltet. Insbesondere ist die Atmosphäre, in welcher die erste Zwischenschicht gewachsen wird, frei von Arsen-haltigen Stoffen. Ferner ist die Atmosphäre, in welcher die zweite Zwischenschicht gewachsen wird, vorzugsweise frei von Phosphor-haltigen Stoffen.

Die erste und die zweite Zwischenschicht können bei derselben Temperatur gewachsen werden. Hierbei kann die Temperatur etwa 700°C betragen. Nach dem Aufwachsen der zweiten Zwischenschicht erfolgt vorzugsweise eine Wachstumsunterbrechung, innerhalb welcher die Temperatur abgesenkt wird. Die Wachstumsunterbrechung kann mehrere Minuten andauern.

Im Gegensatz zu einem herkömmlichen Prozess erfolgt die Temperaturabsenkung nicht unter Phosphin-Stützdruck mit den anfangs genannten Nachteilen, sondern unter Arsin-Stützdruck. Dies hat einerseits den Vorteil, dass der Halbleiterchip eine verbesserte Morphologie aufweist, und anderseits, dass ein Memory-Effekt deutlich unterdrückt ist.

Gemäß einer bevorzugten Ausgestaltung wird nach der Wachstumsunterbrechung die Kontaktschicht gewachsen. Dies kann bei einer Temperatur von etwa 550°C durchgeführt werden.

Alternativ kann eine Temperaturabsenkung bereits beim Aufwachsen der ersten und/oder zweiten Zwischenschicht beginnen. Dies hat den Vorteil, dass auf die Wachstumsunterbrechung vor dem Aufwachsen der Kontaktschicht verzichtet oder dass die Wachstumsunterbrechung verkürzt werden kann.

Der p-dotierte Bereich kann mittels verschiedener Dotierstoffe dotiert werden. Beispielsweise können die Mantelschicht und die erste Zwischenschicht mit Magnesium oder Zink dotiert werden. Für die zweite Zwischenschicht und die Kontaktschicht sind vorliegend Kohlenstoff wie auch Zink oder Magnesium als Dotierstoffe besonders geeignet.

Vorteilhafterweise ermöglicht das Wachstum der zweiten Zwischenschicht, die vorzugsweise AlGaAs enthält, auch bei hohen Temperaturen einen ausreichend hohen Einbau von Kohlenstoff, Magnesium oder Zink in die zweite Zwischenschicht. Daher kann das Umschalten von Phosphor-basierendem Wachstum auf Arsen-basierendes Wachstum bei hohen Temperaturen ohne Wachstumsunterbrechung erfolgen. Die elektrischen Eigenschaften des Halbleiterchips können dadurch deutlich verbesert werden, da die Löcherleitung verbessert beziehungsweise der Serienwiderstand reduziert ist.

Um einen Halbleiterchip herzustellen, der in der ersten und der zweiten Zwischenschicht eine sich kontinuierlich ändernde Konzentration der ersten Materialkomponente aufweist, wird während des Aufwachsens der ersten und der zweiten Zwischenschicht die Konzentration der ersten Materialkomponente in der Atmosphäre kontinuierlich abgesenkt.

Weitere Merkmale, Vorteile und Weiterbildungen der Erfindung ergeben sich aus den nachfolgend in Verbindung mit den Figuren 1 bis 8 erläuterten Ausführungsbeispielen.

Es zeigen:
Figur 1 eine schematische Querschnittsansicht eines Ausführungsbeispiels eines erfindungsgemäßen Halbleiterchips,
Figur 2 eine schematische Querschnittsansicht eines Ausführungsbeispiels eines herkömmlichen Halbleiterchips,
Figur 3 ein Schaubild darstellend die Defektdichte D des erfindungsgemäßen und herkömmlichen Halbleiterchips,
Figur 4 ein Schaubild darstellend die Rauhigkeit R des erfindungsgemäßen und herkömmlichen Halbleiterchips,
Figur 5 ein Schaubild darstellend Stromspannungskurven des erfindungsgemäßen und herkömmlichen Halbleiterchips,
Figur 6 ein Schaubild darstellend den elektrischen Widerstand E des erfindungsgemäßen und herkömmlichen Halbleiterchips,
Figuren 7A und 7B ein Schaubild darstellend einen Verlauf des Valenzbandes VB und des Leitungsbandes LB bei einem herkömmlichen Halbleiterchip und einem erfindungsgemäßen Halbleiterchip,
Figuren 8A bis 8D eine schematische Darstellung verschiedener Verfahrensschritte zur Herstellung eines erfindungsgemäßen Halbleiterchips.

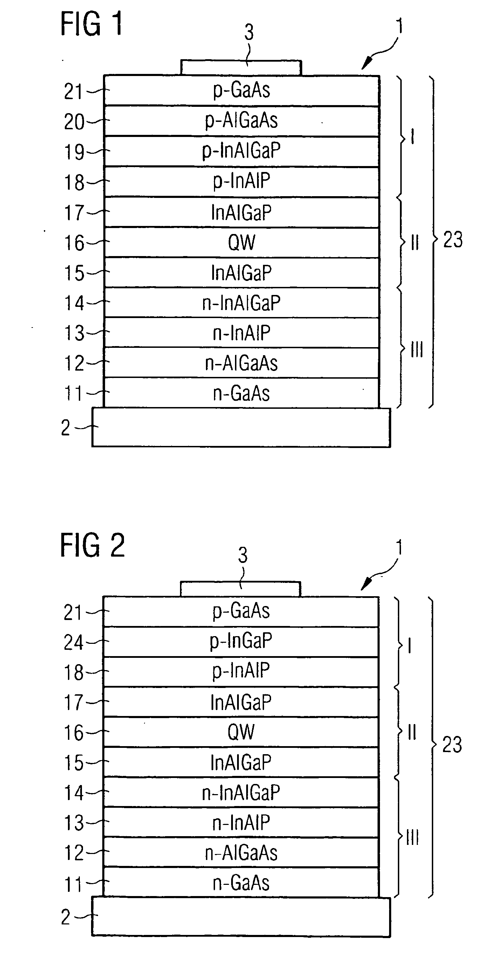

Der in Figur 1 dargestellte Halbleiterchip 1 umfasst eine Halbleiter-Schichtenfolge 23, die rückseitig auf einem Träger 2 angeordnet und vorderseitig mit einer Kontaktmetallisierung 3 zur elektrischen Kontaktierung des Halbleiterchips 1 versehen ist. Der Träger 2 kann ein für das Aufwachsen der Schichtenfolge 23 verwendetes Aufwachssubstrat oder alternativ ein Montagekörper sein, auf welchen die Schichtenfolge 23 nach der Herstellung aufgebracht wurde. Ferner kann auf dem Träger 2 ein weiterer elektrischer Kontakt vorgesehen sein.

Die Schichtenfolge 23 weist drei verschiedene Bereiche auf, einen p-dotierten Bereich I, einen aktiven Bereich II und einen n-dotierten Bereich III.

Der p-dotierte Bereich I umfasst eine Mantelschicht 18, eine erste Zwischenschicht 19, eine zweite Zwischenschicht 20 und eine Kontaktschicht 21. Der aktive Bereich II umfasst eine undotierte Quantentopfschicht 16 und Barriereschichten 15 und 17, die ebenfalls undotiert sind. An den aktiven Bereich II schließt sich der n-dotierte Bereich III an, der eine dotierte Barriereschicht 14, eine Mantelschicht 13 sowie eine Zwischenschicht 12 und eine Kontaktschicht 11 aufweist. Bevorzugte Dotierstoffe für die n-Dotierung sind Silizium und Tellur. Für die p-Dotierung wird in der Mantelschicht 18 und in der ersten Zwischenschicht 19 vorzugsweise Mg oder Zn verwendet, während zur p-Dotierung der zweiten Zwischenschicht 20 und der Kontaktschicht 21 vorzugsweise C eingesetzt wird. Es ist jedoch auch möglich, in der zweiten Zwischenschicht 20 und der Kontaktschicht 21 Mg oder Zn zu verwenden.

Die einzelnen Schichten der Schichtenfolge 23 weisen unterschiedliche Dicken auf, die sich in einem Bereich von wenigen Nanometern bis hin zu mehreren hundert Nanometern bewegen.

In dem vorliegend beschriebenen Ausführungsbeispiel ist die erste Materialkomponente, deren Konzentration y sich innerhalb der ersten Zwischenschicht 19 und der zweiten Zwischenschicht 20 ändert, Aluminium. Insbesondere ändert sich die Konzentration y derart, dass die Bandlücke in einem Bereich variiert, der zwischen der Bandlücke der Mantelschicht 19 und der Bandlücke der Kontaktschicht 22 liegt. Als zweite Materialkomponente, deren Konzentration 1-y ebenfalls variiert, wird vorliegend Gallium verwendet. Indium liegt als dritte Materialkomponente mit konstanter Konzentration x in der ersten Zwischenschicht 19 vor.

In der nachfolgenden Tabelle sind Werte für die Al-Konzentration, die Ga-Konzentration, die Dicke und die Dotierstoffkonzentration in den einzelnen Schichten angegeben:

| | Al-Konzentration y [%] | Ga-Konzentration 1-y [%] | Dicke [nm] | Dotierstoffkonzentration [n/cm-3] |
|---|---|---|---|---|
| Schicht 11 | | | 200 | 2.4*10¹⁸ (Si) |
| Schicht 12 | 40 | 60 | 200 | 2.9*10¹⁸(Si) |
| Schicht 13 | 100 | 0 | 800 | 2.0*10¹⁸(Si) |
| Schicht 14 | 40 | 60 | 20 | 2.1*10¹⁸(Si) |
| Schicht 15 | 40 | 60 | 230 | |
| Schicht 16 | | | 5 | |
| Schicht 17 | 40 | 60 | 250 | |
| Schicht 18 | 100 | 0 | 800 | 2.9*10¹⁷ (Mg) |
| Schicht 19 | 70 -> 20 | 30->80 | 20 | 1.1*10¹⁷ -> |
| | | | | 2.9*10¹⁷ (Mg) |
| Schicht 20 | 60 -> 5 | 40 -> 95 | 60 | 3.7*10¹⁸ -> |
| | | | | 1.1*10¹⁹ (C) |
| Schicht 21 | 0 | 100 | 400 | 1*10²⁰ -2*10²⁰ (C) |

Wie aus der Tabelle hervorgeht, ist die Al-Konzentration y mit 100% in der Mantelschicht 18 maximal, während sie in der Kontaktschicht 21 einen minimalen Wert von 0% annimmt. In der ersten Zwischenschicht 19 sinkt die Al-Konzentration y ausgehend von der Mantelschicht 18 bis hin zur zweiten Zwischenschicht 20 von 70% auf 20% ab. Die Absenkung erfolgt innerhalb der ersten Zwischenschicht 19 vorzugsweise kontinuierlich und setzt sich nicht bis in die zweite Zwischenschicht 20 fort. Vielmehr startet die Al-Konzentration y in der zweiten Zwischenschicht 20 bei einem neuen Wert, der höher ist als der Endwert der Al-Konzentration y in der ersten Zwischenschicht 19 und hier 60% beträgt. Die Al-Konzentration y nimmt in der zweiten Zwischenschicht 20, vorzugsweise kontinuierlich, bis auf einen Wert von 5% ab.

Vorteilhafterweise kann mittels der ersten Zwischenschicht 19 und der zweiten Zwischenschicht 20 ein Bandoffset zwischen der Mantelschicht 18 und der Kontaktschicht 21, das heißt der Größenunterschied in der Bandlücke zwischen der Mantelschicht 18 und der Kontaktschicht 21, gegenüber einem herkömmlichen Halbleiterchip reduziert werden.

In Figur 2 ist zum Vergleich ein herkömmlicher Halbleiterchip 1 dargestellt, der anstelle der ersten und der zweiten Zwischenschicht eine p-dotierte Zwischenschicht 24 ohne Al-Gehalt aufweist.

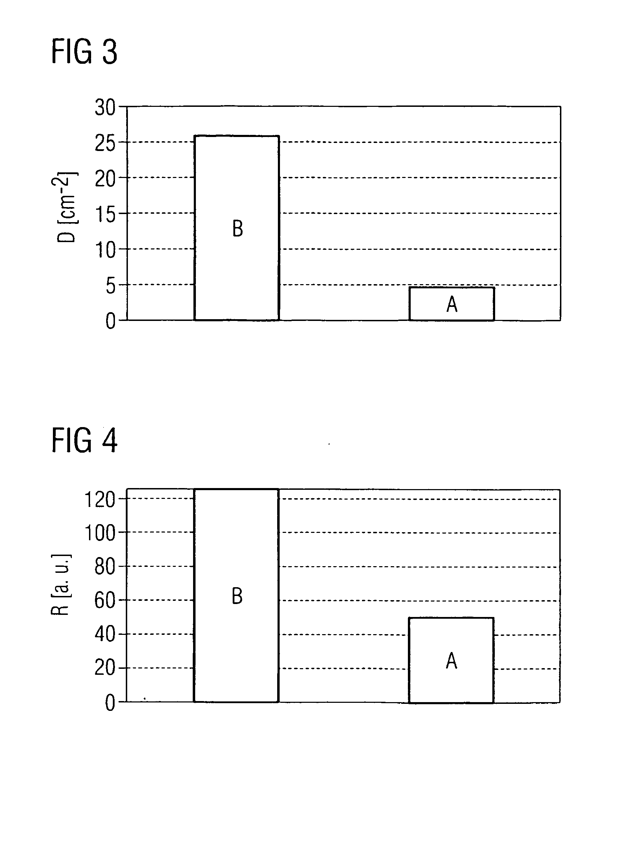

Figur 3 zeigt ein Schaubild mit Werten der Defektdichte D, die im Falle (A) des erfindungsgemäßen Halbleiterchips entsprechend dem in Figur 1 dargestellten Ausführungsbeispiel und im Falle (B) des herkömmlichen Halbleiterchips gemäß dem in Figur 2 dargestellten Ausführungsbeispiel auftreten. Wie zu erkennen ist, liegt der Wert bei dem in Figur 2 dargestellten Halbleiterchip (26 cm-2) um etwa einen Faktor 5 höher als bei dem Halbleiterchip gemäß Figur 1 (5 cm-2). Eine geringere Defektdichte D hat den Vorteil, dass sich die Lebensdauer des Halbleiterchips erhöhen kann.

In dem Schaubild der Figur 4 sind Werte für die Rauhigkeit R einer vorderseitigen Oberfläche des Halbleiterchips entsprechend dem in Figur 1 dargestellten Ausführungsbeispiel (A) und des Halbleiterchips gemäß dem in Figur 2 dargestellten Ausführungsbeispiel (B) gezeigt. Es geht daraus hervor, dass die vorderseitige Oberfläche des Halbleiterchips gemäß Figur 2 um etwa einen Faktor 2.5 rauher ist als die vorderseitige Oberfläche des Halbleiterchips gemäß Figur 1. Eine verringerte Rauhigkeit R ist ein Indiz für eine verbesserte Kristallqualität.

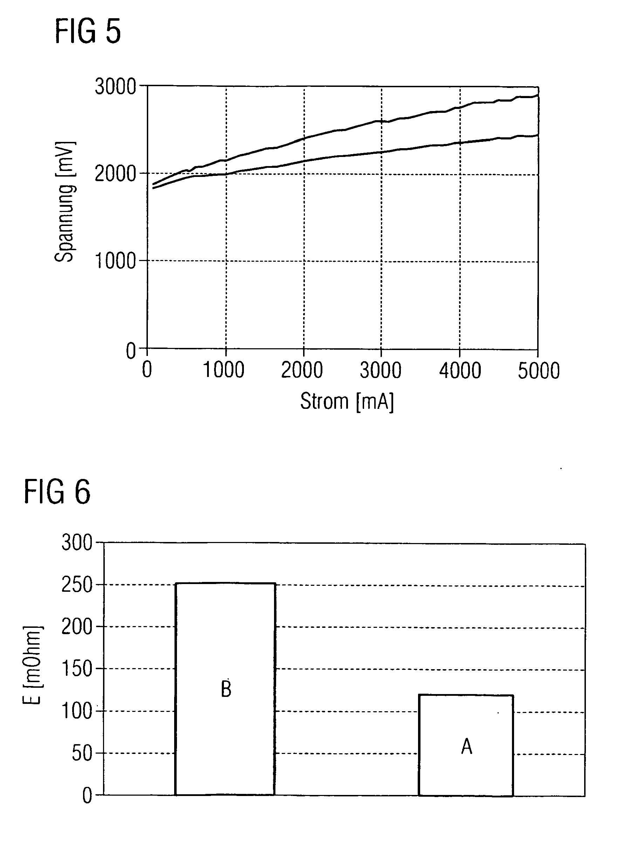

Das Schaubild der Figur 5 zeigt Strom-Spannungskennlinien für den Halbleiterchip entsprechend dem in Figur 1 dargestellten Ausführungsbeispiel (A) und den Halbleiterchip gemäß dem in Figur 2 dargestellten Ausführungsbeispiel (B). Im Falle des Halbleiterchips gemäß Figur 1 ist ein geringerer Anstieg der Spannung bei Zunahme des Stroms zu verzeichnen. Folglich erfordert der Halbleiterchip gemäß Figur 1 bei gleicher optischer Ausgangsleistung eine geringere elektrische Leistung.

In dem Schaubild der Figur 6 sind Werte für den elektrischen Widerstand E des Halbleiterchips entsprechend dem in Figur 1 dargestellten Ausführungsbeispiel (A) und den Halbleiterchip gemäß dem in Figur 2 dargestellten Ausführungsbeispiel (B) aufgetragen. Dem Schaubild kann für den Halbleiterchip gemäß Figur 2 ein Wert (252 mOhm) entnommen werden, der etwa das doppelte des Werts (119 mOhm) des Halbleiterchips gemäß Figur 1 beträgt. Eine Verringerung des elektrischen Widerstands E führt zu der bereits im Zusammenhang mit Figur 5 erwähnten Reduzierung der elektrischen Leistungsaufnahme bei dem Halbleiterchip gemäß Figur 1.

In dem in Figur 7A gezeigten Schaubild ist der simulierte Verlauf des Valenzbandes VB und des Leitungsbandes LB eines Halbleiterchips gemäß Figur 2 dargestellt. Die eingekreiste Stelle verdeutlicht die Problematik bei einem herkömmlichen Halbleiterchip. Am Übergang zwischen der Mantelschicht und der Kontaktschicht treten im Valenzband "Spikes" auf, die eine Barriere für Löcher darstellen.

Hingegen ist dem in Figur 7B simulierten Verlauf des Valenzbandes VB eines Halbleiterchips gemäß Figur 1 ein annähernd flaches Profil am Übergang zwischen der Mantelschicht 18 und der Kontaktschicht 21 zu entnehmen. Vorteilhafterweise entfällt somit bei einem wie in Figur 1 dargestellten Halbleiterchip die Barriere für Löcher.

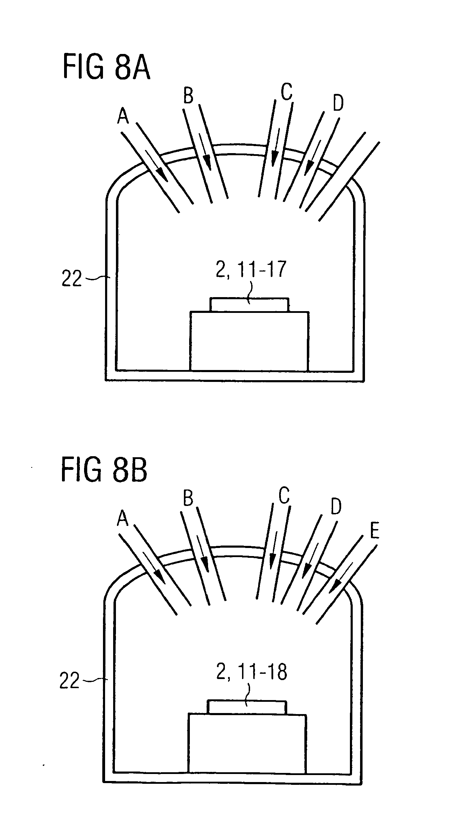

Die epitaktischen Schichten, deren Herstellung in den Figuren 8A bis 8D schematisch dargestellt ist, werden mittels MOVPE aufgewachsen.

Figur 8A zeigt einen Herstellungsschritt zum Aufwachsen der p-dotierten Mantelschicht (vgl. Figur 1, Mantelschicht 18). Die dafür benötigten Materialkomponenten A, B, C und D werden in gasförmigem Zustand durch entsprechende Zuleitungen in eine Reaktorkammer 22 eingeleitet. Die Materialkomponente A entspricht einem Phosphor-haltigen Gas, insbesondere Phosphin, die Materialkomponente B einem Aluminium-haltigen Gas, die Materialkomponente C einem Indium-haltigen Gas und die Materialkomponente D einem ersten p-Dotierstoff, insbesondere Mg. Das Wachstum der p-dotierten Mantelschicht erfolgt bei einer Temperatur zwischen etwa 700°C und 800°C. Auch die Schichten 11 bis 17, worauf die p-dotierte Mantelschicht abgeschieden wird, sind bei dieser Temperatur hergestellt. Die resultierende p-dotierte Mantelschicht hat die in der Tabelle für die Schicht 18 angegebenen Eigenschaften.

In Figur 8B ist ein Herstellungsschritt zum Abscheiden der ersten Zwischenschicht (vgl. Figur 1, erste Zwischenschicht 19) schematisch dargestellt. Hierbei wird eine weitere Materialkomponente E zugeführt, die einem Gallium-haltigen Gas entspricht. Die Wachstumstemperatur ändert sich im Vergleich zu dem vorausgehenden Herstellungsschritt (Figur A) nicht. Jedoch wird die Konzentration der Materialkomponente B, wie aus der Tabelle für die erste Zwischenschicht 19 hervorgeht, kontinuierlich abgesenkt. Die Konzentration der Materialkomponente E wird gleichzeitig erhöht. Zusätzlich wird die Konzentration der Materialkomponente D, das heißt des p-Dotierstoffs,erhöht.

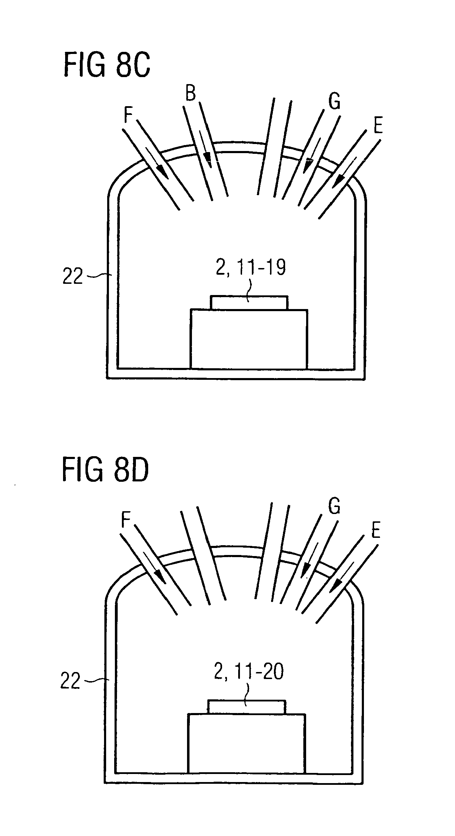

Bei gleich bleibender Temperatur wird in einem in Figur 8C dargestellten nächsten Herstellungsschritt die zweite Zwischenschicht (vgl. Figur 1, zweite Zwischenschicht 20) aufgewachsen. Hierzu werden weiterhin die Materialkomponenten B und E in die Reaktorkammer 22 eingeleitet. Die Materialkomponente C wird hingegen weggelassen. Ferner wird die Materialkomponente A durch die Materialkomponente F ersetzt, die nicht notwendigerweise durch dieselbe Zuleitung wie die Materialkomponente A geführt werden muss. Die Materialkomponente F ist ein Arsen-haltiges Gas, insbesondere Arsin. Vorzugsweise wird das Umschalten von Phosphor-basierendem Wachstum auf Arsen-basierendes Wachstum instantan vollzogen, das heißt, dass das Abschalten einer Phosphor-haltigen Gasquelle gleichzeitig mit dem Anschalten einer Arsen-haltigen Gasquelle erfolgt. Auch bei diesem Herstellungsschritt wird die Konzentration der Materialkomponente B kontinuierlich heruntergefahren und die Konzentration der Materialkomponente E kontinuierlich erhöht (vgl. Tabelle, zweite Zwischenschicht 20). Anstelle der Materialkomponente D wird die Materialkomponente G beigefügt, die einem zweiten Dotierstoff, insbesondere Kohlenstoff, entspricht. Wie aus der Tabelle ersichtlich ist, wird die Materialkomponente G stetig erhöht.

Zwischen den in Figur 8C und Figur 8D dargestellten Herstellungsschritten wird eine wenige Minuten andauernde Wachstumspause von vorzugsweise 3min bis 5min eingelegt. In dieser Wachstumspause wird die Temperatur auf etwa 540°C abgesenkt, was vorzugsweise unter Arsin-Stützdruck geschieht. Bei dieser Temperatur wird dann die p-dotierte Kontaktschicht (vgl. Figur 1, Kontaktschicht 21) aus den Materialkomponenten G und E aufgewachsen und mit der Materialkomponente F p-dotiert. Genauere Angaben hierzu sind in der Tabelle zu finden.

## Patentansprüche

1. Halbleiterchip (1) mit einem p-dotierten Bereich (I), der eine Mantelschicht (18) und eine Kontaktschicht (21) aufweist, wobei zwischen der Mantelschicht (18) und der Kontaktschicht (21) eine erste Zwischenschicht (19) und eine zweite Zwischenschicht (20) angeordnet sind und wobei sich eine Konzentration y einer ersten Materialkomponente (B) innerhalb der ersten und der zweiten Zwischenschicht (19, 20) derart ändert, dass die Bandlücke innerhalb der ersten und der zweiten Zwischenschicht (19, 20) in einem Bereich variiert, der zwischen der Bandlücke der Mantelschicht (18) und der Bandlücke der Kontaktschicht (21) liegt, wobei
- die Mantelschicht (18), die erste Zwischenschicht (19), die zweite Zwischenschicht (20) und die Kontaktschicht (21) jeweils ein Verbindungshalbleitermaterial enthalten und für eine Zusammensetzung des jeweiligen Verbindungshalbleitermaterials folgende Formel gilt:
CₓB_{y(1-x)}E_{(1-y)(1-x)}A, wobei 0 ≤ x ≤ 1 und 0 ≤ y ≤ 1 ist,
- die Konzentration y der ersten Materialkomponente (B) innerhalb der ersten Zwischenschicht (19) ausgehend von der Mantelschicht (18) bis hin zur zweiten Zwischenschicht (20) abnimmt,
- die Konzentration y der ersten Materialkomponente (B) innerhalb der zweiten Zwischenschicht (20) ausgehend von der ersten Zwischenschicht (19) bis hin zur Kontaktschicht (21) abnimmt, **dadurch gekennzeichnet, dass**
- die Konzentration y der ersten Materialkomponente (B) in der zweiten Zwischenschicht (20) bei einem Wert startet, der höher ist als der Endwert der Konzentration y in der ersten Zwischenschicht (19).

2. Halbleiterchip (1) nach Anspruch 1, wobei
die Größe der Bandlücke innerhalb der ersten Zwischenschicht (19) ausgehend von der Mantelschicht (18) bis hin zur zweiten Zwischenschicht (20) und innerhalb der zweiten Zwischenschicht (20) ausgehend von der ersten Zwischenschicht (19) bis hin zur Kontaktschicht (21) abnimmt.

3. Halbleiterchip (1) nach Anspruch 1, wobei
eine erste Materialkomponente (B) Aluminium, eine zweite Materialkomponente (E) Gallium, eine dritte Materialkomponente (C) Indium und eine vierte Materialkomponente (A) Phosphor oder Arsen ist.

4. Halbleiterchip (1) nach Anspruch 1, wobei
die Konzentration y der ersten Materialkomponente (B) innerhalb der ersten Zwischenschicht (19) auf einer der Mantelschicht (18) zugewandten Seite zwischen einschließlich 20% und 100%, insbesondere zwischen einschließlich 70% und 90%, und auf einer der zweiten Zwischenschicht (20) zugewandten Seite zwischen einschließlich 0% und 50%, insbesondere zwischen einschließlich 10% und 40%, beträgt.

5. Halbleiterchip (1) nach Anspruch 1, wobei
die Konzentration y der ersten Materialkomponente (B) innerhalb der zweiten Zwischenschicht (20) auf einer der ersten Zwischenschicht (19) zugewandten Seite zwischen einschließlich 10% und 100%, insbesondere zwischen einschließlich 60% und 80%, und auf einer der Kontaktschicht (21) zugewandten Seite zwischen einschließlich 0% und 50%, insbesondere zwischen einschließlich 2% und 5%, beträgt.

6. Verfahren zur Herstellung eines Halbleiterchips (1) nach einem der Ansprüche 1 bis 5 umfassend folgende Schritte:
- Aufwachsen der ersten Zwischenschicht (19) auf die Mantelschicht (18),
- Aufwachsen der zweiten Zwischenschicht (20) auf die erste Zwischenschicht (19),
- Aufwachsen der Kontaktschicht (21) auf die zweite Zwischenschicht (20).

7. Verfahren nach Anspruch 6, wobei
ein Aufwachsen der zweiten Zwischenschicht (20) auf die erste Zwischenschicht (19) ohne Wachstumsunterbrechung erfolgt.

8. Verfahren nach Anspruch 6 oder 7, wobei
zwischen dem Aufwachsen der ersten und der zweiten Zwischenschicht (19, 20) von Phosphor-basierendem Wachstum auf Arsen-basierendes Wachstum umgeschaltet wird.

9. Verfahren nach Anspruch 8, wobei
die erste und die zweite Zwischenschicht (19, 20) bei derselben Temperatur, insbesondere bei etwa 700°C, gewachsen werden.

10. Verfahren nach Anspruch 8 oder 9, wobei
nach dem Aufwachsen der zweiten Zwischenschicht (21) eine Wachstumsunterbrechung erfolgt, innerhalb welcher die Temperatur, vorzugsweise unter Arsin-Stützdruck, abgesenkt wird.

11. Verfahren nach Anspruch 10, wobei
die Kontaktschicht (21) bei einer Temperatur von etwa 550° gewachsen wird.

12. Verfahren nach einem der Ansprüche 6 bis 11, wobei
während des Aufwachsens der ersten und der zweiten Zwischenschicht (19, 20) die Konzentration der ersten Materialkomponente (B) kontinuierlich abgesenkt wird.

## Claims

1. Semiconductor chip (1) comprising a p-doped region (I) having a cladding layer (18) and a contact layer (21), wherein a first interlayer (19) and a second interlayer (20) are arranged between the cladding layer (18) and the contact layer (21), and wherein a concentration y of a first material component (B) within the first and the second interlayer (19, 20) changes in such a way that the band gap varies within the first and the second interlayer (19, 20) in a range lying between the band gap of the cladding layer (18) and the band gap of the contact layer (21), wherein
- the cladding layer (18), the first interlayer (19), the second interlayer (20) and the contact layer (21) in each case contain a compound semiconductor material and the following formula holds true for a composition of the respective compound semiconductor material:
CₓB_{y(1-x)}E_{(1-y)(1-x)}A, where 0 ≤ x ≤ 1 and 0 ≤ y ≤ 1,
- the concentration y of the first material component (B) within the first interlayer (19) decreases proceeding from the cladding layer (18) towards the second interlayer (20),
- the concentration y of the first material component (B) within the second interlayer (20) decreases proceeding from the first interlayer (19) towards the contact layer (21), **characterized in that**
- the concentration y of the first material component (B) in the second interlayer (20) starts at a value which is higher than the end value of the concentration y in the first interlayer (19).

2. Semiconductor chip (1) according to Claim 1,
wherein
the size of the band gap within the first interlayer (19) decreases proceeding from the cladding layer (18) towards the second interlayer (20) and within the second interlayer (20) decreases proceeding from the first interlayer (19) towards the contact layer (21).

3. Semiconductor chip (1) according to Claim 1,
wherein
a first material component (B) is aluminium,
a second material component (E) is gallium,
a third material component (C) is indium and
a fourth material component (A) is phosphorus or arsenic.

4. Semiconductor chip (1) according to Claim 1,
wherein
the concentration y of the first material component (B) within the first interlayer (19), on a side facing the cladding layer (18), is between 20% and 100% inclusive, in particular between 70% and 90% inclusive, and, on a side facing the second interlayer (20), is between 0% and 50% inclusive, in particular between 10% and 40% inclusive.

5. Semiconductor chip (1) according to Claim 1,
wherein
the concentration y of the first material component (B) within the second interlayer (20), on a side facing the first interlayer (19), is between 10% and 100% inclusive, in particular between 60% and 80% inclusive, and, on a side facing the contact layer (21), is between 0% and 50% inclusive, in particular between 2% and 5% inclusive.

6. Method for producing a semiconductor chip (1) according to any of Claims 1 to 5, comprising the following steps:
- growing the first interlayer (19) onto the cladding layer (18),
- growing the second interlayer (20) onto the first interlayer (19),
- growing the contact layer (21) onto the second interlayer (20).

7. Method according to Claim 6, wherein
the second interlayer (20) is grown onto the first interlayer (19) without any interruption of growth.

8. Method according to Claim 6 or 7, wherein
between growing the first and the second interlayer (19, 20), a changeover is made from phosphorus-based growth to arsenic-based growth.

9. Method according to Claim 8, wherein
the first and the second interlayer (19, 20) are grown at the same temperature, in particular approximately 700°C.

10. Method according to Claim 8 or 9, wherein
an interruption of growth takes place after the second interlayer (20) has been grown, the temperature being reduced within said interruption of growth, preferably under arsine supporting pressure.

11. Method according to Claim 10, wherein
the contact layer (21) is grown at a temperature of approximately 550°.

12. Method according to any of Claims 6 to 11, wherein
the concentration of the first material component (B) is reduced continuously in the course of growing the first and the second interlayer (19, 20).

## Revendications

1. Puce semi-conductrice (1) avec une zone dopée p (I), laquelle présente une couche de gaine (18) et une couche de contact (21), une première couche intermédiaire (19) et une seconde couche intermédiaire (20) étant disposées entre la couche de gaine (18) et la couche de contact (21) et une concentration y d'un premier composant de matériau (B) à l'intérieur des première et seconde couches intermédiaires (19, 20) se modifiant de manière telle que l'écart énergétique à l'intérieur des première et seconde couches intermédiaires (19, 20) varie dans une plage, laquelle se situe entre l'écart énergétique de la couche de gaine (18) et l'écart énergétique de la couche de contact (21), moyennant quoi
- la couche de gaine (18), la première couche intermédiaire (19), la seconde couche intermédiaire (20) et la couche de contact (21) contiennent respectivement un matériau semi-conducteur de liaison, la formule suivante s'appliquant pour une composition du matériau semi-conducteur de liaison respectif :
CₓB_{y(1-x)}E_{(1-y)(1-x)}A, avec 0 ≤ x ≤ 1 et 0 ≤ y ≤ 1,
- la concentration y du premier composant de matériau (B) à l'intérieur de la première couche intermédiaire (19) diminuant en partant de la couche de gaine (18) jusqu'à la seconde couche intermédiaire (20),
- la concentration y du premier composant de matériau (B) à l'intérieur de la seconde couche intermédiaire (20) diminuant en partant de la première couche intermédiaire (19) jusqu'à la couche de contact (21), **caractérisée en ce que**
- la concentration y du premier composant de matériau (B) dans la seconde couche intermédiaire (20) commence avec une valeur, laquelle est supérieure à la valeur finale de la concentration y dans la première couche intermédiaire (19).

2. Puce semi-conductrice (1) selon la revendication 1, dans laquelle la taille de l'écart énergétique à l'intérieur de la première couche intermédiaire (19) diminue en partant de la couche de gaine (18) jusqu'à la seconde couche intermédiaire (20), et à l'intérieur de la seconde couche intermédiaire (20), en partant de la première couche intermédiaire (19) jusqu'à la couche de contact (21).

3. Puce semi-conductrice (1) selon la revendication 1, dans laquelle un premier composant de matériau (B) est de l'aluminium, un deuxième composant de matériau (E) étant du gallium, un troisième composant de matériau (C) étant de l'indium et un quatrième composant de matériau (A) étant du phosphore ou de l'arsenic.

4. Puce semi-conductrice (1) selon la revendication 1, dans laquelle la concentration y du premier composant de matériau (B) à l'intérieur de la première couche intermédiaire (19) est comprise entre 20% et 100% de manière inclusive, en particulier entre 70% et 90% de manière inclusive sur un côté faisant face à la couche de gaine (18), et est comprise entre 0% et 50% de manière inclusive, en particulier entre 10% et 40% de manière inclusive sur un côté faisant face à la seconde couche intermédiaire (20).

5. Puce semi-conductrice (1) selon la revendication 1, dans laquelle la concentration y du premier composant de matériau (B) à l'intérieur de la seconde couche intermédiaire (20) est comprise entre 10% et 100% de manière inclusive, en particulier entre 60% et 80% de manière inclusive sur un côté faisant face à la première couche intermédiaire (19), et est comprise entre 0% et 50% de manière inclusive, en particulier entre 2% et 5% de manière inclusive sur un côté faisant face à la couche de contact (21).

6. Procédé pour la fabrication d'une puce semi-conductrice (1) selon l'une des revendications 1 à 5 comprenant les étapes suivantes :
- faire croître la première couche intermédiaire (19) sur la couche de gaine (18),
- faire croître la seconde couche intermédiaire (20) sur la première couche intermédiaire (19),
- faire croître la couche de contact (21) sur la seconde couche intermédiaire (20).

7. Procédé selon la revendication 6, dans lequel une croissance de la seconde couche intermédiaire (20) sur la première couche intermédiaire (19) s'effectue sans interruption de croissance.

8. Procédé selon les revendications 6 ou 7, dans lequel, entre la croissance de la première et de la seconde couche intermédiaire (19, 20), on passe d'une croissance à base de phosphore à une croissance à base d'arsenic.

9. Procédé selon la revendication 8, dans lequel on fait croître les première et seconde couches intermédiaires (19, 20) à la même température, en particulier à environ 700°C.

10. Procédé selon les revendications 8 ou 9, dans lequel, après la croissance de la seconde couche intermédiaire (20), il y a une interruption de croissance pendant laquelle on abaisse la température, de préférence sous une pression d'appoint d'arsine.

11. Procédé selon la revendication 10, dans lequel on fait croître la couche de contact (21) avec une température d'environ 550°C.

12. Procédé selon l'une des revendications 6 à 11, dans lequel, pendant la croissance des première et seconde couches intermédiaires (19, 20), on diminue de manière continue la concentration du premier composant de matériau (B).
